# EUROPEAN PATENT SPECIFICATION

(11) **EP 3 304 005 B1**
(45) Date of publication and mention of the grant of the patent: **22.12.2021**
(21) Application number: 16730135.7
(22) Date of filing: 01.06.2016
(51) Int. Cl.: G01D 11/30, H05K 1/16, H05K 1/18, H05K 3/34

(54) **INTEGRATED CIRCUIT WITH SENSOR PRINTED IN SITU**
INTEGRIERTE SCHALTUNG MIT IN-SITU GEDRUCKTEM SENSOR
CIRCUIT INTÉGRÉ AVEC CAPTEUR IMPRIMÉ IN SITU

(30) Priority: 02.06.2015 US 201562169986 P; 31.05.2016 US 201615169456
(43) Date of publication of application: 11.04.2018
(73) Proprietor: Microchip Technology Incorporated, Chandler, Arizona 85224-6199 (US)
(72) Inventor: YACH, Randy L., Phoenix, Arizona 85048 (US); ECK, Arthur B., Gilbert, Arizona 85234 (US)
(74) Representative: sgb europe
(86) International application number: PCT/US2016/035187
(87) International publication number: WO 2016/196572

(56) References cited:
- EP-A1- 1 281 946
- WO-A1-2010/102721
- US-A1- 2006 214 666
- US-A1- 2009 141 767
- US-A1- 2010 127 084
- US-A1- 2016 093 548
- US-B1- 9 164 052

## Description

The present disclosure relates to integrated circuits, and specifically integrated circuits with sensors printed in situ thereon.

Surface mount technology refers to methods for producing electronic circuits in which various components are mounted on the surface of a printed circuit board (PCB). Such a circuit may be called a surface mount device. Surface mount methods may be preferred in place of "through-hole" mounting techniques because they allow mounting smaller components on both sides of the PCB and increased component density, both of which reduce the overall size, and may be simpler to automate.

An integrated electronic sensor in form of a single chip wireless sensor is known from US Patent Application US 2009/0141767. US Patent Application US 2010/0127084 discloses printed antennas, methods of printing an antenna and devices including the printed antenna. US Patent Application US 2016/0093548 discloses a semiconductor package with a printed sensor. US Patent US 9,165,052 discloses an integrated gas sensor.

Many sensors that would be otherwise useful with integrated circuits (IC) are compromised by the solder reflow or wave solder processes employed in surface mounting. For example, some sensors used to detect chemicals may be damaged if subjected to high temperature. If a temperature-sensitive sensor is to be mounted on a printed circuit board (PCB), it must be connected after soldering is complete. This post-soldering step, sometimes referred to as one or more "secondary attachment" processes, entails additional cost and time requirements.

In addition, secondary attachment processes result in increased physical distance between the sensor and the signal processing apparatus (e.g., an IC chip or die) when compared to sensors that are placed prior to the soldering step. Increased physical distance decreases the signal-to-noise ratio of the sensor output to the IC die. Reducing the physical distance between the two, therefore, would improve the performance of the sensors in a given application.

This is achieved by the method as defined in the independent claim 1. Further enhancements are characterized in the dependent claims. According to the invention, a method is provided for manufacturing a module comprising an integrated circuit and a sensor includes: mounting an integrated circuit (IC) die on a printed circuit board (PCB) using a high temperature process to provide an electrical connection between interconnects of the PCB and the die, wherein the high temperature mounting process is defined as a soldering process, a reflow soldering process, or a wave soldering process; wherein the IC die is encapsulated by an encapsulation material; wherein a portion of the encapsulation material formed on a top side of the IC die includes one opening, said opening exposing at least one electrical contact on the top side of the IC die; and printing a sensor directly onto the top side of the IC die after all high temperature mounting processes are complete, wherein printing the sensor directly onto the exposed at least one electrical contact thereby provides an electrical connection between the IC die and the sensor.

The top surface of the housing thus defines an opening that exposes a portion of the IC die; and the method includes printing the sensor device directly onto the exposed IC die.

The top surface of the housing thus defines an opening that exposes a portion of the IC die and the exposed portion of the IC die includes a plurality of exposed electrical contact areas.

Accoding to the invention, mounting the IC die to a printed circuit board with a high temperature mounting process is performed before printing the sensor device.

According to the invention, the high temperature mounting process includes a soldering process, a reflow soldering process, or a wave soldering process.
FIGURE 1 is a drawing showing an example sensor module not forming part of the invention.
FIGURE 2 is a drawing showing an example sensor module not forming part of the invention.
FIGURES 3A and 3B are drawings illustrating an example sensor module before and after printing a sensor thereon, not forming part of the present invention.
FIGURES 4A and 4B are drawings showing an example sensor module before and after printing a sensor on the encapsulated IC die, not forming part of the present invention. .
FIGURES 5A and 5B are drawings illustrating an example sensor module before and after printing a sensor thereon, according to the present invention. .
FIGURE 6 is a flowchart showing an example method for manufacturing a module comprising an integrated circuit and a sensor. .
FIGURE 7 is a flowchart showing an example method for manufacturing a module comprising an integrated circuit and a sensor, not forming part of the present invention.

Various assembly techniques may be used to surface mount an IC die to a PCB. The PCB normally has a plurality of leads to allow electrical connection to the leads of the IC die. Solder paste may be applied to the PCB using a screen printing and/or stencil process. In automated systems, the components to be mounted may be placed by "pick-and-place" machines.

The PCBs, along with the various components, may be placed in a reflow soldering oven. The oven may raise the temperature of the PCB, the components, and the solder paste. When the temperature reaches the melting point of the solder particles in the solder paste, the component leads are thereby bonded to the contact points on the PCB. In some systems, the temperature is raised using infrared lamps. In other systems, hot gas convection may use air and/or nitrogen gas. In another alternative, vapor phase reflow may use fluorocarbon liquids with high boiling points.

In some devices, once an IC component is mounted to a PCB, it may be further packaged for protection from mechanical damage, thermal damage, radio frequency noise emission, electrostatic discharge, etc. Some devices may include "glob-top" or "glop-top" packaging. Glob-top coating may include a drop of epoxy or resin deposited over the IC die or chip and any leads or connections to the PCB, after the IC die has been connected to the PCB (*e.g.,* by soldering). Glob-top coating may be appropriate for IC dies mounted directly to a PCB, sometimes called "chip-on-board" (COB) mounting.

In other devices, an IC die may be encapsulated in a plastic housing before mounting to the PCB. Various standardized packages may be used, including as examples, dual-in-line, quad-in-line, grid arrays, small outline transistors, etc. Such ICs may be called encapsulated or packaged.

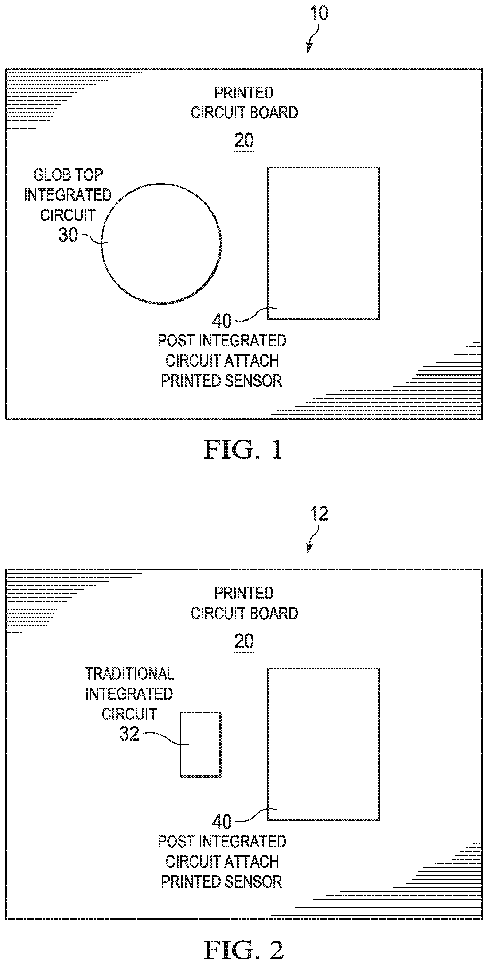

FIGURE 1 is a drawing showing an example sensor module 10, not forming part of the invention. The example shown includes a COB IC die 30 surface mounted to a PCB 20 and then coated with a glob-top epoxy, along with a sensor 40 printed onto the PCB 20 after the surface mounting process was completed. PCB 20 may include various leads, circuitry, etc. to provide appropriate electrical communication between IC die 30 and sensor 40.

FIGURE 2 is a drawing showing an example sensor module 12 not forming part of the invention. The example shown includes an encapsulated IC die 32 surface mounted to a PCB 20, along with a sensor 40 printed onto the PCB 20 after the surface mounting process was completed. PCB 20 may include various leads, circuitry, etc., to provide appropriate electrical connections between IC die 32 and sensor 40.

In some examples, such as those shown in FIGURES 1 and 2, sensor 40 may include a chemical and/or gas sensor. Various types of sensors may be manufactured by printing processes. For example, glucose sensors for the treatment of diabetes are generally manufactured using a printing process. Other examples include biosensors, capacitive sensors, piezoresistive sensors, piezoelectric sensors, photodetectors, temperature sensors, humidity sensors, and gas sensors. Example printing processes include screen printing (e.g., "thick film" processes), pad printing, additive manufacturing, PiezoPaint, and/or selective sintering processes.

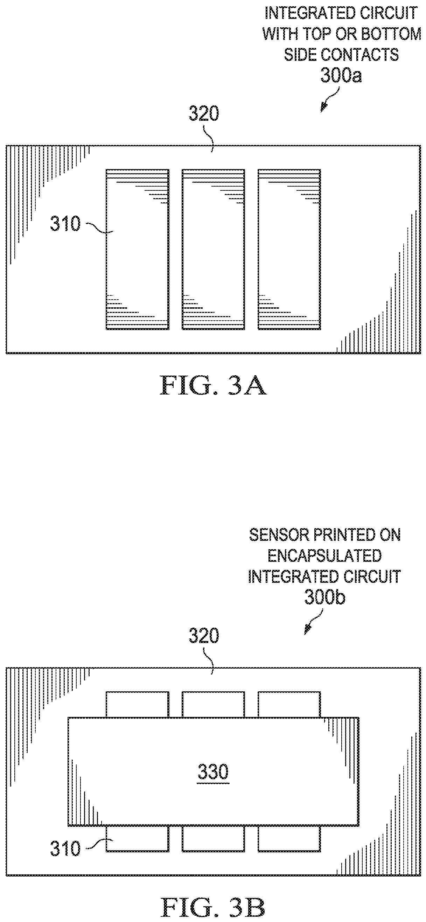

FIGURES 3A and 3B are drawings illustrating an example sensor module 300 before (300a) and after (300b) printing a sensor 330 thereon, not forming part of the present invention.

Sensor module 300a may include an encapsulated IC 320 with exposed body surface contacts 310. In the example shown, there are three top surface contacts, but the teachings of this example may be practiced with any appropriate number of surface contacts. In general, the exposed body surface contacts 310 may be on the opposite side of the encapsulated IC 320 from any leads and/or mounting features which will be used to connect IC 320 to a PCB (not shown in FIGS. 3A and 3B). While the integrated circuit die is encapsulated within the housing 320, the contact areas 310 may provide an available electrical connection to the encapsulated die.

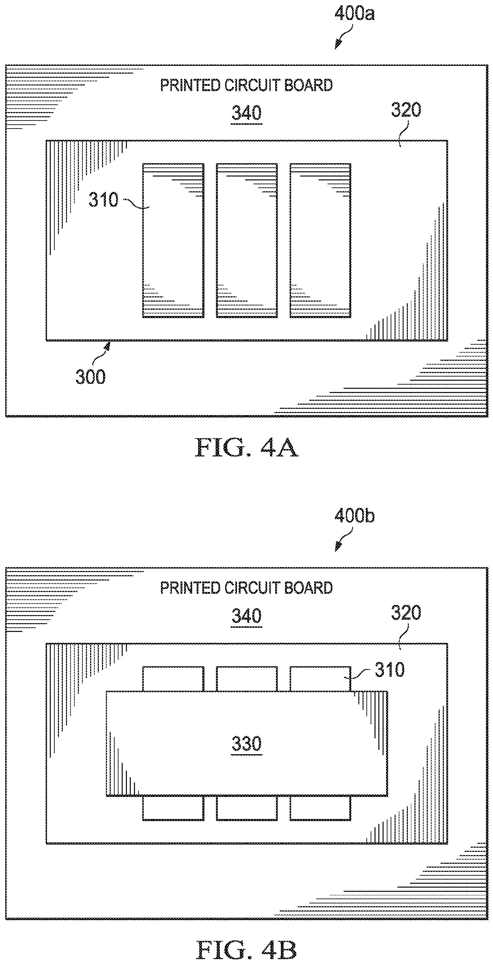

Then, the sensor 330 may be printed on top of the encapsulated IC 320 thereby connecting to the top surface contacts as shown in Fig. 3B. Sensor module 300b may then be attached to a printed circuit board, module, etc. providing a sensor module similar to that shown in Fig. 4B, including a sensor module including encapsulated IC die 320 with exposed body surface contacts 310 and sensor 330 printed thereon. The entire module 300b may be attached to a socket on the printed circuit board 300. Use of a socket may avoid exposure to high temperatures that would occur during a surface mounting/soldering procedure, for example.

FIGURES 4A and 4B are drawings showing an example sensor module 400 before (400a) and after (400b) printing a sensor 330 on the encapsulated IC die 320, not forming part of the present invention. Encapsulated die 320 may be mounted to PCB 340 using a surface mount/soldering technique, in contrast to the examples shown in FIGS. 3A and 3B, because sensor 330 is not yet present as shown in FIG. 4A. Encapsulated IC 320 may include exposed body surface contacts 310. In the example shown, there are three top surface contacts, but the teachings of this example may be practiced with any appropriate number of surface contacts. In general, the exposed body surface contacts 310 may be on the opposite side of the encapsulated IC 320 from any leads and/or mounting features which were used to connect IC 320 to a PCB 340. While the integrated circuit die is encapsulated within the housing 320, the contact areas 310 may provide an available electrical connection to the encapsulated die.

Then, the sensor 330 may be printed on top of the encapsulated IC 320 thereby connecting to the top surface contacts as shown in Fig. 4B. Sensor module 400b then operates normally in electrical connection to PCB 340 and IC 320.

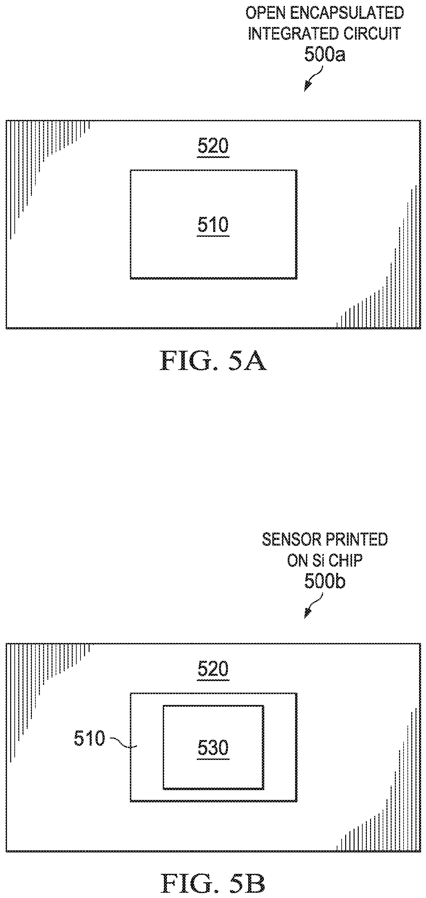

FIGURES 5A and 5B are drawings illustrating an example sensor module 500 before (500a) and after (500b) printing a sensor 530 thereon, according to teachings of the present invention. Sensor module 500a includes an encapsulated IC 520 with an opening 510 exposing a portion of the IC die within. In general, the exposed portion 510 of the IC die may be on the opposite side of the encapsulated IC 520 from any leads and/or mounting features which will be used to connect IC 520 to a PCB (not shown in FIGS. 5A and 5B). While the integrated circuit die is encapsulated within the housing 520, the exposed area 510 provides an available electrical connection to the encapsulated die.

Then, the sensor 530 is printed on top of the encapsulated IC 520 thereby connecting to the top surface contacts as shown in Fig. 5B. The opening 510 may be designed to stay open to provide an exposure of the printed sensor 530 to the environment. However, according to some embodiments, the opening may also be closed for sensors that do not require exposure, for example certain temperature sensors.

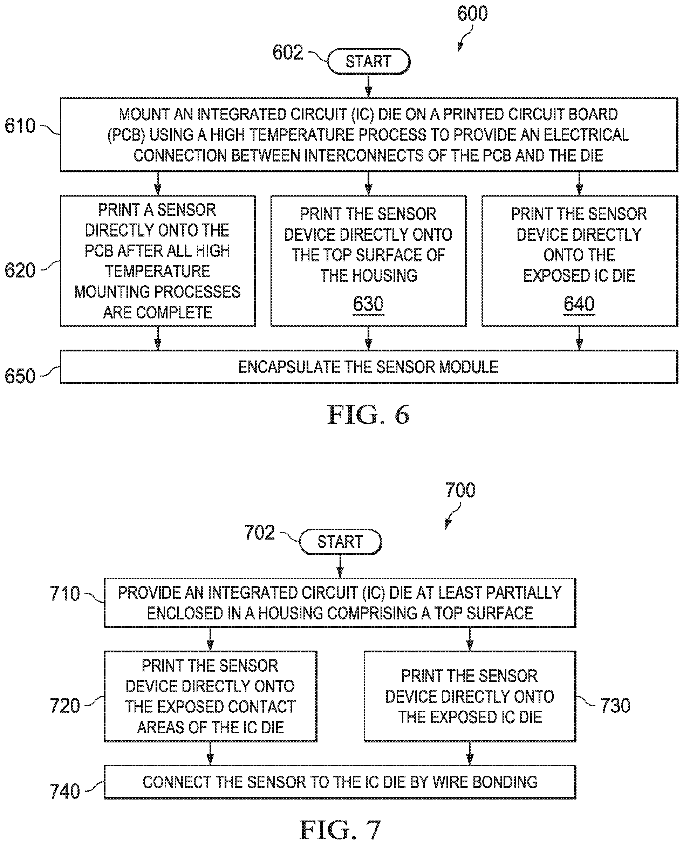

FIGURE 6 is a flowchart showing an example method 600 for manufacturing a module comprising an integrated circuit and a sensor. Persons having ordinary skill in the art will be able to alter the order of some steps of method 600 and leave others out completely.

At Step 602, method 600 begins.

Step 610 includes mounting an IC die on a PCB using a high temperature process to provide an electrical connection between interconnects of the PCB and the die. Step 610 includes any appropriate surface mounting process. The IC die may be unencapsulated, fully encapsulated, or partially encapsulated. Depending on the type of packaging for the IC die, method 600 may include any of Steps 620, 630, or 640.

Step 620 includes printing a sensor directly onto the PCB after all high temperature mounting processes are complete. Step 620 may be appropriate for glob-top IC dies or fully encapsulated dies with no available connections for the sensor, such as the examples shown in FIGURES 1 and 2. In some examples, , the IC die may have exposed portions but the sensor may be printed directly onto the PCB because of the size and/or spacing needs for the IC die and/or the sensor.

Step 630 includes printing the sensor device directly onto a top surface of the housing or an encapsulated die. Step 630 may be appropriate for IC dies partially encapsulated with exposed contact areas, such as the examples shown in FIGURES 3A-4B.

Step 640 includes printing the sensor device directly onto the exposed IC die, according to the present invention. . Step 640 may be appropriate for IC dies only partially encapsulated with exposed portions of the IC die, sometimes called "open encapsulated ICs", such as the embodiments shown in FIGURES 5A and 5B.

In method 600 as shown, all branches return to Step 650. Step 650 includes encapsulating the sensor module. The sensor may be encapsulated and/or left exposed depending on the form and function of the sensor. For example, temperature sensors may be encapsulated while gas and/or chemical sensors may be left exposed to the surrounding atmosphere.

FIGURE 7 is a flowchart showing an example method 700 for manufacturing a module comprising an integrated circuit and a sensor not forming part of the present invention. Persons having ordinary skill in the art will be able to alter the order of some steps of method 700 and leave others out completely.

At Step 702, method 700 begins.

Step 710 includes providing an IC die at least partially enclosed in a housing comprising a top surface. The IC die may be fully encapsulated or partially encapsulated. Depending on the type of packaging for the IC die, method 700 may include Step 720 or 730.

Step 720 includes printing the sensor device directly onto the exposed contact areas of the IC die. Step 720 may be appropriate for IC dies partially encapsulated with exposed contact areas, such as the examples shown in FIGURES 3A-4B.

Step 730 includes printing the sensor device directly onto the exposed IC die. Step 730 may be appropriate for IC dies only partially encapsulated with exposed portions of the IC die, sometimes called "open encapsulated ICs", such as the embodiments shown in FIGURES 5A and 5B.

In method 700 as shown, all branches return to Step 740. Step 740 includes connecting the sensor to the IC die by wire bonding. Step 740 may not be necessary if the sensor device is printed in such a manner that the connections are made by the printing process.

In some examples of method 700, the sensor module may be mounted on a PCB without using a high temperature process, thereby providing an electrical connection between interconnects of the PCB and the die. For example, the sensor module may be plugged into a socket on the PCB.

## Claims

1. A method for manufacturing a sensor module comprising an integrated circuit and a sensor, the method comprising:
mounting an integrated circuit, IC die on a printed circuit board, PCB (20), using a high temperature mounting process to provide an electrical connection between interconnects of the PCB (20) and the IC die,
wherein the high temperature mounting process is defined as a soldering process, a reflow soldering process, or a wave soldering process,
wherein the IC die is encapsulated by an encapsulation material,
wherein a portion of the encapsulation material formed on a top side of the IC die includes one opening, said opening exposing at least one electrical contact (510) on the top side of the IC die; and
printing a sensor (530) directly onto the top side of the IC die after all high temperature mounting processes are complete,
wherein printing the sensor (530) directly onto the exposed at least one electrical contact thereby provides an electrical connection between the IC die (520) and the sensor (530).

2. A method according to Claim 1, further comprising the step of:
encapsulating the sensor module after printing the sensor (530).

3. A method according to Claim 2, wherein the sensor (530) is a temperature sensor and is encapsulated.

4. A method according to one of the preceding Claims 1-5, wherein the mounting of the IC die onto the PCB (20) is performed in an automated system.

5. A method according to one of the preceding Claims 1-4, wherein the at least one electrical contact (510) provides an available electrical connection to the encapsulated die (520).

## Patentansprüche

1. Verfahren zum Herstellen eines Sensormoduls, das eine integrierte Schaltung und einen Sensor aufweist, wobei das Verfahren aufweist:
Montieren eines integrierten Schaltungs- (IC-) Chips auf eine gedruckte Leiterplatte, PCB (20), unter Verwendung eines Hochtemperatur-Montageprozesses, um eine elektrische Verbindung zwischen Verbindungen der PCB (20) und dem IC-Chip bereitzustellen,
wobei der Hochtemperatur-Montageprozess als Lötprozess, Reflow-Lötprozess oder Schwall-Lötprozess definiert ist,
wobei der IC-Chip durch ein Einkapselungsmaterial eingekapselt ist,
wobei ein Abschnitt des Verkapselungsmaterials, der auf einer Oberseite des IC-Chips ausgebildet ist, eine Öffnung aufweist, wobei die Öffnung zumindest einen elektrischen Kontakt (510) auf der Oberseite des IC-Chips freilegt; und
Drucken eines Sensors (530) direkt auf die Oberseite des IC-Chips, nachdem alle Hochtemperatur-Montageprozesse abgeschlossen sind,
wobei das direkte Drucken des Sensors (530) auf den freigelegten zumindest einen elektrischen Kontakt dadurch eine elektrische Verbindung zwischen dem IC-Chip (520) und dem Sensor (530) bereitstellt.

2. Verfahren gemäß Anspruch 1, das weiterhin den Schritt aufweist:
Einkapseln des Sensormoduls nach dem Drucken des Sensors (530).

3. Verfahren gemäß Anspruch 2, wobei der Sensor (530) ein Temperatursensor ist und eingekapselt ist.

4. Verfahren gemäß einem der vorhergehenden Ansprüche 1 bis 5, wobei die Montage des IC-Chips auf der PCB (20) in einem automatisierten System durchgeführt wird.

5. Verfahren gemäß einem der vorhergehenden Ansprüche 1 bis 4, wobei der zumindest eine elektrische Kontakt (510) eine verfügbare elektrische Verbindung zum eingekapselten Chip (520) bereitstellt.

## Revendications

1. Procédé de fabrication d'un module de capteur comprenant un circuit intégré et un capteur, le procédé comprenant :
le montage d'une puce de circuit intégré, CI, sur une carte de circuit imprimé, PCB (20), au moyen d'un processus de montage à haute température pour fournir une liaison électrique entre des interconnexions de la PCB (20) et de la puce CI,
dans lequel le processus de montage à haute température est défini comme un processus de soudure, un processus de soudure par refusion, ou un processus de soudure à la vague,
dans lequel la puce CI est encapsulée par un matériau d'encapsulation,
dans lequel une partie du matériau d'encapsulation formé sur un côté supérieur de la puce CI comprend une ouverture, ladite ouverture exposant au moins un contact électrique (510) sur le côté supérieur de la puce CI ; et
l'impression d'un capteur (530) directement sur le côté supérieur de la puce CI après que tous les processus de montage à haute température sont terminés,
dans lequel l'impression du capteur (530) directement sur l'au moins un contact électrique exposé fournit ainsi une liaison électrique entre la puce CI (520) et le capteur (530).

2. Procédé selon la revendication 1, comprenant en outre l'étape suivante :
l'encapsulation du module de capteur après l'impression du capteur (530).

3. Procédé selon la revendication 2, dans lequel le capteur (530) est un capteur de température et est encapsulé.

4. Procédé selon l'une des revendications précédentes 1 à 5, dans lequel le montage de la puce CI sur la PCB (20) est réalisé dans un système automatisé.

5. Procédé selon l'une des revendications précédentes 1 à 4, dans lequel l'au moins un contact électrique (510) fournit une liaison électrique disponible à la puce (520) encapsulée.
